# EUROPÄISCHE PATENTSCHRIFT

(11) **EP 2 876 083 B1**
(45) Veröffentlichungstag und Bekanntmachung des Hinweises auf die Patenterteilung: **11.09.2019**
(21) Anmeldenummer: 14193445.5
(22) Anmeldetag: 17.11.2014
(51) Int. Cl.: C23C 16/26, C23C 16/452, C23C 16/455, C23C 16/50, C23C 16/46, C23C 16/515, C01B 32/15

(54) **Vorrichtung und Verfahren zum Fertigen von aus Kohlenstoff bestehenden Nano-Strukturen**
Device and method of producing nano-structures consisting of carbon
Procédé et dispositif de fabrication de nanostructures constituées de carbone

(30) Priorität: 21.11.2013 DE 102013112855
(43) Veröffentlichungstag der Anmeldung: 27.05.2015
(73) Patentinhaber: Aixtron SE, 52134 Herzogenrath (DE)
(72) Erfinder: Blackburn, Ian, Woodnewton, Northamptonshire PE8 5EL (GB); Lu, Brian, Fremont, CA 94539 (US); Teo, Kenneth B. K., Cambridge, Cambridgeshire CB23 5BH (GB); Rupesinghe, Nalin L., Cambridge, Cambridgeshire CB4 3NB (GB)
(74) Vertreter: Grundmann, Dirk

(56) Entgegenhaltungen:
- EP-A2- 1 703 552
- GB-A- 2 295 401
- KR-A- 20110 137 217
- US-A1- 2006 228 827
- US-A1- 2010 072 054
- US-B1- 6 200 652
- LE NORMAND F ET AL: "Gas phase and surface kinetics in plasma and hot filament-enhanced catalytic chemical vapor deposition of carbon nanostructures", THIN SOLID FILMS, ELSEVIER-SEQUOIA S.A. LAUSANNE, CH, Bd. 517, Nr. 12, 30. April 2009 (2009-04-30), Seiten 3466-3471, XP026696921, ISSN: 0040-6090, DOI: 10.1016/J.TSF.2009.01.079 [gefunden am 2009-04-16]
- YAP H Y ET AL: "Growth of mechanically fixed and isolated vertically aligned carbon nanotubes and nanofibers by DC plasma-enhanced hot filament chemical vapor deposition", DIAMOND AND RELATED MATERIALS, ELSEVIER SCIENCE PUBLISHERS, AMSTERDAM, NL, Bd. 15, Nr. 10, 1. Oktober 2006 (2006-10-01), Seiten 1622-1628, XP028000718, ISSN: 0925-9635, DOI: 10.1016/J.DIAMOND.2006.01.014 [gefunden am 2006-10-01]

## Beschreibung

Die Erfindung betrifft eine Vorrichtung gemäß des Anspruches 1 sowie ein Verfahren zur Fertigung von aus Kohlenstoff bestehenden Nano-Strukturen unter Verwendung dieser Vorrichtung.

Kohlenstoff kann in verschiedenen kristallinen Strukturen abgeschieden werden. Beispielsweise in Form einer Diamantstruktur, als Monolage, Vielschichtstruktur (multilayer sheets) wie Graphene, als Röhrchen wie "carbon nanotubes" oder als Fullerene oder als Fasern. Zur Abscheidung derartiger Kohlenstoffstrukturen insbesondere von Nano-Strukturen, die Strukturgrößen in zumindest einer Dimension von einem Bruchteil eines Nanometers bis zu wenigen 100 Nanometer besitzen, werden CVD-Vorrichtungen verwendet. Dabei wird zusammen mit einem Trägergas, beispielsweise Argon oder Wasserstoff, ein kohlenstoffhaltiger Ausgangsstoff, beispielsweise Methan oder Azetylen in die Prozesskammer des CVD-Reaktors eingeleitet. Es ist bekannt, die eingeleiteten kohlenstoffhaltigen Ausgangsstoffe thermisch oder mittels eines Plasmas zu aktivieren bzw. zu dissoziieren. Beispielsweise beschreibt die US 8,398,927 B2 eine Plasma-Enhanced-CVD (PE-CVD) und die US 2006/0185595 A1 eine Hot-Filament-CVD (HF-CVD). Bei der PE-CVD wird innerhalb eines Gaseinlassorganes ein Plasma gezündet. Hierzu besitzt die Vorrichtung eine Plasmaelektrode, die mit elektrischer Spannung beaufschlagt wird. Hierdurch werden Radikale erzeugt, die durch die Gasaustrittsöffnung des Gaseinlassorgans in eine Prozesskammer eintreten können, wo sie unter Ausbildung der NanoStrukturen auf einem auf einem Heizelement angeordneten Substrat abgeschieden werden. Bei der HF-CVD wird der kohlenstoffhaltige Ausgangsstoff mit einem heißen Filament innerhalb oder aber auch außerhalb eines Gaseinlassorganes aufgeheizt. Bei der HF-CVD kann unmittelbar oberhalb des Substrates ein Plasma gezündet werden, mit dem Radikale erzeugt werden. Die Zündung eines Plasmas unmittelbar oberhalb des Substrates ist aber nachteilhaft, da sich im Plasma energiereiche Ionen bilden, die auf dem Substrat ätzend wirken.

Eine gattungsgemäße Vorrichtung beschreibt die US 2010/0072054 A1. In einem Gaseinlassorgan befinden sich Plasmaelektroden sowie stromabwärts der Plasmaelektroden angeordnete Schirmelektroden.

Eine Vorrichtung zum Abscheiden kohlenstoffhaltiger Strukturen unter Verwendung eines Plasmas sind darüber hinaus auch aus den US 6,499,425 bzw. US 6,161,499 bekannt.

Die KR 10-2011-0137217 beschreibt eine Vorrichtung zum Abscheiden von Diamantschichten. In einem Gaseinlassorgan soll ein Plasma erzeugt werden. Hierzu ist ein beheizter Draht vorgesehen.

Die US 6,200,652 D1 beschreibt ebenfalls eine Vorrichtung zum Abscheiden von Diamantschichten. Ein aus einem Gaseinlassorgan in eine Prozesskammer einströmendes Prozessgas durchströmt zwei in Strömungsrichtung beabstandete Gitter, zwischen denen ein Plasma gezündet wird.

Der Erfindung liegt die Aufgabe zugrunde, die bekannte Vorrichtung bzw. das bekannte Verfahren mit dem Ziel einer verbesserten Fertigung von aus Kohlenstoff bestehenden Nano-Strukturen zu verbessern.

Gelöst wird die Aufgabe durch die in den Ansprüchen angegebene Erfindung.

Erfindungsgemäß wird innerhalb des Gaseinlassorgans ein Plasma gezündet. Des Weiteren wird eine Gasheizung verwendet, um den gasförmigen Ausgangsstoff zu assoziieren bzw. zu dissoziieren. Es werden gewissermaßen die Vorteile der HF-CVD und der PE-CVD genutzt, so dass sich in einer Kombination einer Plasmadissoziation des gasförmigen Ausgangsstoffes und einer thermischen Aktivierung/Reaktion bzw. einer thermischen Behandlung des Gases innerhalb der Gasphase Reaktionsprodukte bilden. Die bevorzugte Verwendung eines kohlenstoffhaltigen Ausgangsstoffes führt zu einer Bildung polymerischer bzw. aromatischer Komponenten. Es bilden sich insbesondere polymerische bzw. aromatische Radikale. Bevorzugt besitzt der Plasmagenerator geerdete Schirmelektroden, mit denen sich bei der Dissoziation bildende Ionen neutralisiert bzw. gefangen werden können. Die Verwendung einer Schirmelektrode führt auch zu einer Energieverminderung der Ionen. Das erfindungsgemäße Gaseinlassorgan bzw. der erfindungsgemäß verwendete Gasverteiler ist bevorzugt als "shower head" ausgebildet. Die Erzeugung der Radikale erfolgt durch Verwendung sowohl eines Plasmas als auch der Wärmezufuhr. Dies kann mit einer Mehrzahl von gitterförmig ausgebildeten Platten erzeugt werden, wobei sowohl die von elektrischer Spannung beaufschlagbare Plasmaelektrode als auch die stromaufwärts und/ oder stromabwärts der Plasmaelektrode angeordneten Schirmelektroden als Platten mit einer Vielzahl von Öffnungen ausgebildet sind. Die Öffnungen der Platten können versetzt zueinander angeordnet sein, so dass sich eine verbesserte Gasmischung ergibt. Die Gasheizung wird ebenfalls von einer gitterförmigen Struktur ausgebildet, sie hat jedoch zwei Elektroden, um durch die Platte einen die Platte aufheizenden Strom hindurchzuleiten. Die Gasheizung kann aber auch mäanderförmig ausgebildet sein, als Wicklung geformt sein und zwei oder mehrere Elektroden aufweisen, so dass das Heizelement mit einem elektrischen Strom geheizt werden kann. Sämtliche Platten liegen quer zur Strömungsrichtung des Gases und erstrecken sich bevorzugt über die gesamte Querschnittsfläche des Gaseinlassorgans. Die Gasheizung ist insbesondere ein flächiges Objekt, das quer zur Strömungsrichtung angeordnet ist. Die Gasheizung kann innerhalb des Gaseinlassorganes, im Bereich der Gasaustrittsfläche oder unmittelbar stromabwärts der Gasaustrittsfläche angeordnet sein. Die Erstreckungsrichtung der Gasheizung verläuft quer zur Stromrichtung des Gasstroms. Die Platten haben regelmäßig angeordnete Öffnungen. Die Öffnungen können einen rechteckigen, einen runden oder einen länglichen Querschnitt aufweisen. Die Gasheizung ist in der Lage, das durch sie hindurch tretende Gas zu erwärmen, so dass die Gastemperatur angehoben wird.

In einer ersten Variante kann die Plasmaelektrode gleichzeitig das Heizelement ausbilden. Die Plasmaelektrode wird dabei nicht nur von einer elektrischen Hochspannung beaufschlagt, die zur Erzeugung des Plasmas dient. Durch die Platte wird auch ein Strom geleitet, der die Platte aufheizt, so dass mit dieser aufgeheizten Platte nicht nur ein Plasma erzeugt wird, sondern auch das Gas aufgeheizt wird. Es findet am selben Ort somit eine Plasmaaktivierung und eine thermische Aktivierung statt.

In einer zweiten Variante der Erfindung ist die Plasmaelektrode von der Heizeinrichtung räumlich getrennt. Die Heizeinrichtung kann stromabwärts des Plasmagenerators angeordnet sein. Die Platten, die die Elektroden ausbilden, können aus Metall, insbesondere aus hochreflektierendem Metall bestehen. Auch die zur Gehäusehöhlung hin weisende Wandung der Gasaustrittsfläche kann wärmereflektierend ausgebildet sein. Die elektrisch vorgespannte Plasmaelektrode kann zwischen zwei geerdeten Schirmelektroden angeordnet sein. Hierdurch wird der außerhalb liegende Bereich der Gehäusehöhlung gegen ein Ionenbombardement geschützt.

In einer dritten Variante befindet sich die Gasheizung unmittelbar stromabwärts der Gasaustrittsfläche. Stromabwärts der Gasheizung befindet sich eine Löcher aufweisende Platte, die aus einem isolierenden Werkstoff besteht. Die Gasaustrittsfläche sowie die Seitenwandung des Gaseinlassorgans bestehen aus einem elektrisch leitfähigen Werkstoff und sind ebenso wie zwei innerhalb des Gaseinlassorgans stromabwärts der Plasmaelektrode angeordnete Schirmplatten geerdet. Zwischen einer stromaufwärts der Plasmaelektrode angeordneten, geerdeten Schirmelektrode kann sich eine Lochplatte aus einem isolierenden Werkstoff befinden.

In einer vierten Variante der Erfindung wird das Gaseinlassorgan von einem elektrisch leitenden Hohlkörper ausgebildet. Der Hohlkörper besitzt eine Zylinderform und einen kreisförmigen Grundriss. Eine obere Stirnseite des Zylinders ist auf ihrer Innenseite mit einer isolierenden Platte ausgekleidet. Die isolierende Platte kann auch gewissermaßen den Deckel des Gaseinlassorganes ausbilden. Auf ihrer Innenseite trägt die isolierende Platte die mit einer Wechselspannung oder einer Gleichspannung, insbesondere mit einer Hochspannung beaufschlagbare Plasmaelektrode, die bei diesem Ausführungsbeispiel nicht vom Gas durchströmt wird. Innerhalb der Gehäusehöhlung des Gaseinlassorganes befinden sich zwei parallel zueinander und parallel zu den Stirnwänden des Gaseinlassorganes verlaufende Platten aus einem elektrisch leitenden Werkstoff, die Gasdurchtrittsöffnungen aufweisen. Die Platten werden mit Haltestangen an der Decke des Gaseinlassorganes befestigt und sind über die Haltestangen geerdet. Die Haltestangen durchgreifen dabei Öffnungen in der Plasmaelektrode und dem isolierenden Körper, an dem die Plasmaelektrode anliegt. Die Gasheizeinrichtung befindet sich hier außerhalb des Gaseinlassorganes. Die Heizeinrichtung wird von einem flachen Metallstreifen gebildet, der innerhalb einer Ebene strukturiert ist, die sich parallel zur Gasaustrittsebene erstreckt. Der Metallstreifen kann mäanderförmig verlaufen. Er kann aber auch spiralförmig um das Zentrum der kreisscheibenförmigen Heizplatte verlaufen. Die Decke der Prozesskammer wird bei diesem Ausführungsbeispiel von einer isolierenden Platte mit Gasdurchtrittsöffnungen ausgebildet. Auch diese Platte besitzt eine Kreisscheibenform. Sie sitzt unmittelbar stromabwärts der Gasheizfläche. Die Platte ist aus einem isolierenden Werkstoff gefertigt. Unterhalb dieser Platte befindet sich der Suszeptor, der von einer Heizeinrichtung beheizbar oder mittels einer Kühleinrichtung kühlbar ist. Auf dem temperierbaren Suszeptor liegt das Substrat.

Das erfindungsgemäße Gaseinlassorgan ist Teil eines CVD-Reaktors, der ein gasdichtes Reaktorgehäuse aufweist, in dem sich das Gaseinlassorgan befindet. Das Gaseinlassorgan besitzt an seiner Unterseite die Gasaustrittsfläche, die eine Vielzahl von Gasaustrittsöffnungen aufweist, so dass das Gaseinlassorgan duschkopfartig ausgebildet ist. Mit dem Gaseinlassorgan findet eine Gasverteilung statt. Unterhalb des Gaseinlassorgans befindet sich die Prozesskammer, deren Boden von einem beheizbaren Suszeptor ausgebildet ist. Auf dem Suszeptor liegt das zumindest eine Substrat, welches aus Glas bestehen kann. Auf dem Substrat werden die Kohlenstoff-Nano-Strukturen, beispielsweise Graphen oder "carbon nanotubes" abgeschieden. Das Substrat kann auch ein Wafer, eine Folie sein. Es kann aus Glas, Quarz, Metall, Keramik oder einem Polymer sowie aus Silizium bestehen.

Zur Durchführung des Verfahrens wird in das Gaseinlassorgan durch die Gaszuleitung eine Gasmischung eingespeist. Diese kann ein Trägergas, beispielsweise Wasserstoff oder Argon sein. Durch das Gaseinlassorgan kann darüber hinaus ein Kohlenstoffträger, beispielsweise Methan oder Acetylen eingespeist werden. Ein gasförmiger Ausgangsstoff wird innerhalb der Reaktionskammer des Gaseinlassorgans chemisch umgewandelt. Insbesondere erfolgt eine Umwandlung eines kohlenstoffhaltigen Ausgangsstoffs. Dies erfolgt beispielsweise durch Beaufschlagung von Methan durch Wärme und durch ein Plasma. Dabei entstehen Zwischenprodukte wie atomare oder ionisierte Radikale. Es kann sich dabei um aromatische oder polymerische Zwischenprodukte handeln. Diese Kohlenstoffatome beinhaltende Zwischenprodukte werden mit einem Trägergas durch die Gasaustrittsöffnungen hindurch in die Prozesskammer eingeleitet, wo sie auf dem Substrat abgeschieden werden. Hierzu wird das Substrat auf eine Temperatur zwischen 300 und 1.200 Grad Celsius aufgeheizt. Die Gaseinspeisung des kohlenstoffhaltigen Ausgangsstoffs kann pulsweise erfolgen. Es ist aber auch vorgesehen, dass der kohlenstoffhaltige Ausgangsstoff kontinuierlich in das Gaseinlassorgan eingespeist wird. Das Plasma kann kontinuierlich durch eine Wechselspannung oder durch eine Gleichspannung erzeugt werden. Das Plasma kann aber auch lediglich pulsweise gezündet werden. Zur Erzeugung des Plasmas wird die Plasmaelektrode auf eine Spannung von 300 bis 1.500 Volt gebracht. Ist die Plasmaelektrode gleichzeitig das Heizelement, besitzt die Heizspannung ein entsprechend hohes Potential, da die Plasmaversorgungsquelle und die Heizungsversorgungsquelle miteinander verbunden sind. Der Plasmagenerator und die Gasheizeinrichtung können auch verwendet werden um ein Reinigungsgas zu erzeugen. Vor bzw. nach einem Beschichtungsschritt wird ein Reinigungsschritt durchgeführt, bei dem innerhalb des Gaseinlassorgans ein neutrales Gas beispielsweise in reinigende Radikale umgewandelt wird. Mit diesen reinigenden Radikalen können, sich in der Prozesskammer oder in der Gehäusehöhlung des Gaseinlassorgans abgelagerte, Partikel entfernt werden. Ein typisches Verfahren kann einen der folgenden Prozessschritte aufweisen:
a) einen Oxidationsschritt, bei dem Sauerstoffatome oder Ionen mit dem erfindungsgemäßen Gaseinlassoragen gebildet werden, um Substrate oder auf den Substraten abgeschiedene Schichten zu oxidieren;
b) einen Reduktionsschritt, bei dem Reduziermittel wie Wasserstoff oder Ammoniak in Atome, Ionen oder Radikale umgewandelt werden, um Substrate oder auf den Substraten abgeschiedene Schichten zu reduzieren;
c) einen Wachstumsschritt, bei dem eine Gasmischung, die eine kohlenstoffhaltige Komponente, beispielsweise Methan, Ethylen oder Acetylen in Atome, Ionen, aromatische oder polymerische Radikale umgeformt wird, um Kohlenstoff-Nano-Material abzuscheiden;
d) einen Nachbehandlungsschritt, bei dem reduzierende oder dotierende Gase verwendet werden.

Ausführungsbeispiele der Erfindung werden nachfolgend anhand beigefügter Zeichnungen erläutert. Es zeigen:
- Fig. 1: eine schematische Darstellung eines CVD-Reaktors gemäß einem ersten Ausführungsbeispiel,
- Fig. 2: die schematische Darstellung eines CVD-Reaktors gemäß einem zweiten Ausführungsbeispiel,
- Fig. 3: ein drittes Ausführungsbeispiel der Erfindung und
- Fig. 4: ein viertes Ausführungsbeispiel der Erfindung.

Die in den Zeichnungen dargestellten CVD-Reaktoren besitzen jeweils ein gasdichtes Reaktorgehäuse 1. Innerhalb des Reaktorgehäuses 1 befindet sich ein Suszeptor 17, der auf eine Prozesstemperatur zwischen 300 und 1.200 Grad aufheizbar ist. Auf der nach oben weisenden Oberseite des Suszeptors 17 befindet sich ein Substrat 16, auf dessen nach oben weisenden Oberseite Kohlenstoff-Nano-Strukturen in Form von Graphene oder carbon nanotubes aber auch Graphen-Monoschichten oder Graphen-Vielschichten oder Fasern abgeschieden werden sollen.

Oberhalb und mit einem Abstand zum Suszeptor erstreckt sich die Gasaustrittsfläche 4 eines Gaseinlassorgans 2. Die Gasaustrittsfläche 4 besitzt eine Vielzahl gitternetzartig angeordneter Gasaustrittsöffnungen 7. Das Gaseinlassorgan 2 hat eine Gestalt, die einem Duschkopf ähnlich ist, so dass das Gaseinlassorgan 2 auch als shower head bezeichnet wird.

In das Gaseinlassorgan 2 mündet eine Gaszuleitung 6. Es können auch mehrere Gaszuleitungen sein, wenn mehrere voneinander verschiedene Prozessgase in das Gaseinlassorgan 2 eingespeist werden sollen. Die Prozessgase werden in einem nicht dargestellten Gasmischsystem bereitgestellt.

Das Gaseinlassorgan 2 ist von Wandungen 3, 3', 3" ringsumschlossen. Innerhalb der Wandungen 3, 3', 3", 4 des Gaseinlassorgans 2 befindet sich eine Gehäusehöhlung 5, die eine Reaktionskammer darstellt, in der eine Vorreaktion der Gase stattfindet, bei der beispielsweise kohlenstoffhaltige Gase dissoziiert werden und sich aromatische bzw. polymerische Zwischenprodukte bilden. Bei den Zwischenprodukten handelt es sich insbesondere um Radikale. Diese werden mit Hilfe des Trägergases durch die Gasaustrittsöffnungen 7 zum Substrat 16 transportiert, wo sie unter Ausbildung der aus Kohlenstoff bestehenden Nano-Strukturen, insbesondere Graphen-Schichten oder Röhrchen abgeschieden werden.

Innerhalb der Gehäusehöhlung 5 des Gaseinlassorgans 2 befinden sich mehrere sich parallel zueinander und parallel zur Gasaustrittsfläche 4 erstreckende Platten 8, 9, 10, 11. Diese Platten erstrecken sich über den gesamten Querschnitt der Gehäusehöhlung 5 und besitzen eine Vielzahl von regelmäßig angeordneten Öffnungen. Zur Verbesserung einer Gasmischung sind die Öffnungen voneinander verschiedener und benachbarter Platten versetzt zueinander angeordnet.

Die Platte 9 ist gegenüber dem Gehäuse des Gaseinlassorgans 2 isoliert und wird mittels einer Hochspannungsquelle 14 mit hochgespanntem Wechsel- oder Gleichstrom beaufschlagt, so dass sich innerhalb der Gehäusehöhlung 5 ein Plasma ausbilden kann. Die Plasmaelektrode 9 liegt zwischen zwei Schirmelektroden 8, 10, die jeweils geerdet sind.

Es ist ein Heizelement 11 vorgesehen. Das Heizelement 11 besitzt zwei Kontakte 12, 13, die an einer Heizspannungsquelle 15 angeschlossen sind, so dass durch das Heizelement 11 ein elektrischer Strom fließen kann, der das Heizelement 11 aufgrund seines Widerstandes beheizt. Die dem Heizelement 11 unmittelbar benachbarten Platten 8, bzw. 10 und die Innenwandung der Gasaustrittsfläche 4 können wärmereflektierend ausgebildet sein.

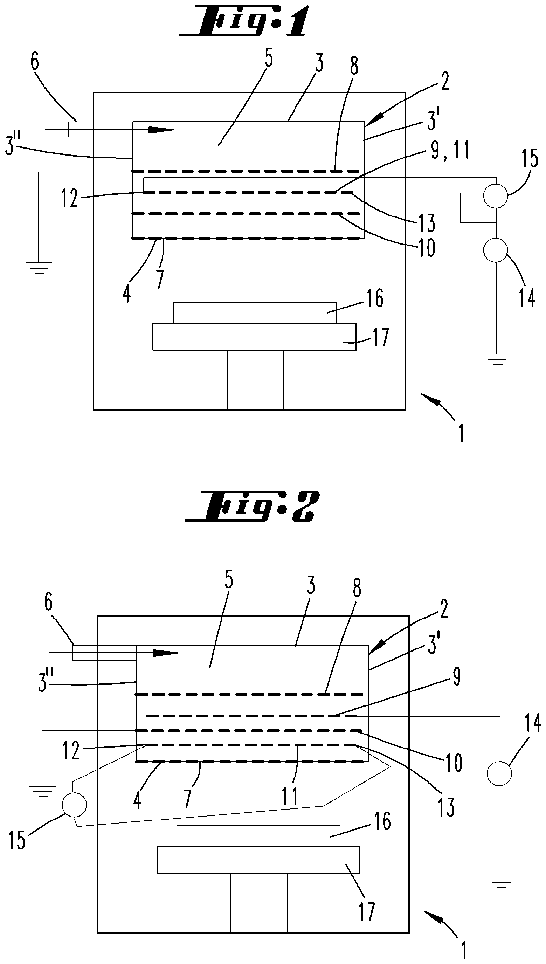

Bei dem in der Figur 1 dargestellten Ausführungsbeispiel wird das Heizelement von der Plasmaelektrode 9 selbst ausgebildet. Die Heizstromquelle 15 ist hier mit der Plasmaspannungsquelle 14 in Reihe geschaltet, so dass durch die Plasmaelektrode 9, die die Anschlusselektroden 12, 13 aufweist, ein elektrischer Strom fließen kann, der die Plasmaelektrode 9 aufheizt.

Bei dem in der Figur 2 dargestellten Ausführungsbeispiel sind Plasmaelektrode 9 und Heizelement 11 räumlich voneinander getrennt. Hier liegt das Heizelement 11 zwischen der unteren Schirmelektrode 10 und der parallel zu der Schirmelektrode 10 verlaufenden Gasaustrittsfläche 4, die von der unteren Wandung des Gaseinlassorgans 2 ausgebildet ist. Hier ist auch die Stromquelle 15 von der Spannungsquelle 14 getrennt.

Während bei dem in der Figur 1 dargestellten Ausführungsbeispiel die Schirmelektroden 8, 10 als Reflektoren für die vom Heizelement 11 abgestrahlte Wärme dient, dienen bei dem in der Figur 2 dargestellten Ausführungsbeispiel die Schirmelektrode 10 und die untere Wandung des Gaseinlassorgans 2 als Reflektoren.

Das Heizelement 11 kann eine Platte sein. Es kann auch ein mäanderförmiges Element oder eine Spule, insbesondere eine Flachspule sein.

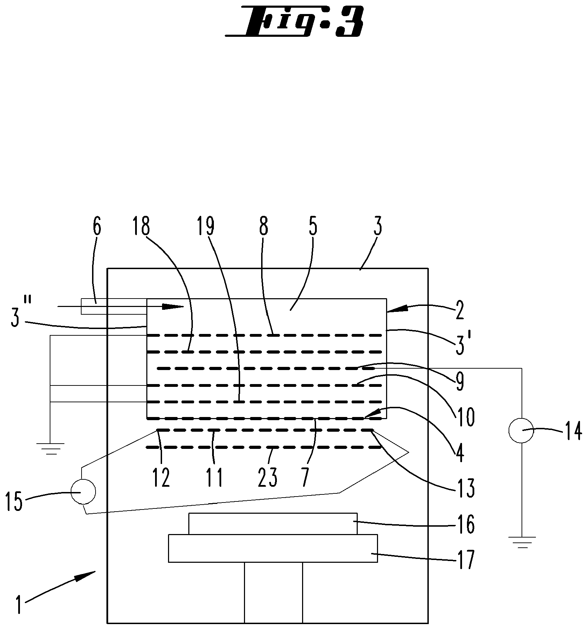

Das in der Fig. 3 gezeigte dritte Ausführungsbeispiel besitzt ein Reaktorgehäuse 1, welches eine Zylinderform mit kreisförmiger Grundflächesich aufweisen kann. Innerhalb des Reaktorgehäuses 1 befindet sich ein Suszeptor 17, der eine Heizung oder eine Kühleinrichtung aufweisen kann.

Auf dem Suszeptor 17 befindet sich ein zu beschichtendes Substrat 16.

Ein einem vertikalen Abstand oberhalb des Suszeptors 17 erstreckt sich über die gesamte Fläche des Suszeptors 17 eine Gasdurchtrittsöffnungen aufweisende Platte 23, die aus einem isolierenden Werkstoff gefertigt ist. In einem geringen Abstand oberhalb der Platte 23 erstreckt sich ein metallischer, flacher, spiralförmiger oder mäanderförmiger Streifen, der an seinen Enden Kontakte 12, 13 ausbildet. Der Streifen bildet ein sich über die Zylinderfläche erstreckendes Heizelement 11 aus, das von einer Heizspannungsquelle 15 mit elektrischer Leistung versorgt werden kann.

Oberhalb des Heizelementes 11, das sich parallel zur Platte 23 erstreckt, erstreckt sich in einer Parallellage die Gasaustrittsfläche 4 des Gaseinlassorganes 2. Die Gasaustrittsfläche 4 besitzt eine Vielzahl von Gasaustrittsöffnungen 7. Das Gehäuse des Gaseinlassorganes 2 besteht aus Metall und ist geerdet.

Unmittelbar oberhalb der Gasaustrittsöffnung 7, also innerhalb der Gehäusehöhlung 5 des Gaseinlassorganes 2, erstrecken sich parallel zur Gasaustrittsfläche 4 verlaufend zwei metallische Platten 10, 19, die geerdet sind. Stromaufwärts des Paares dieser Schirmplatten 10, 19 erstreckt sich die Plasmaelektrode 9, die von einer Hochspannungsquelle 14 spannungsversorgt wird, um innerhalb der Höhlung 5 des Gaseinlassorganes 2 ein Plasma auszubilden.

Stromaufwärts der Plasmaelektrode 9, die sich über die gesamte Querschnittsfläche der Gehäusehöhlung 5 erstreckt, befindet sich eine weitere Isolatorplatte 18 mit Gasdurchtrittsöffnungen. Stromaufwärts der Isolatorplatte 18 befindet sich eine weitere metallische Erdungsplatte ebenfalls mit Durchtrittsöffnungen.

Der durch die Gaszuleitung 6 einströmende Gasstrom, der die zuvor beschriebenen Prozessgase enthält, tritt in die Gehäusehöhlung 5 ein und passiert die Öffnungen der innerhalb der Gehäusehöhlung 5 angeordneten Platten 8,18, 9, 10, 19 und tritt durch die Gasaustrittsöffnung 7 aus dem Gaseinlassorgan 2 aus.

Mit der innerhalb der Gehäusehöhlung 5 vorgesehenen Plasmaelektrode 9 wird ein Plasma erzeugt. Dieses Plasma ist räumlich auf das Gebiet zwischen den geerdeten Platten 8 bzw. 10 beschränkt. die Plasmaelektrode 9 liegt zwischen zwei geerdeten Elektroden 8,10, wobei sich zwischen der oberhalb der Plasmaelektrode 9 angeordneten geerdeten Schirmplatte 8 und der Plasmaelektrode 9 eine aus einem isolierenden Werkstoff gefertigte Isolatorplatte 18 befindet. Mit dem Plasma erfolgt eine physikalische Zerlegung, zumindest aber Ionisierung der Prozessgase. Die derart dissoziierten oder angeregten Prozessgase treten aus den Gasaustrittsöffnungen 7 aus der Gasaustrittsfläche 4 aus und werden beim Durchtritt durch die Spalte zwischen den aufgeheizten Flächenelementen des Heizelementes 11 thermisch aktiviert. Die derart thermisch aktivierten Ausgangsstoffe treten durch die Gasaustrittsöffnungen der isolierenden Platte 23 in die Prozesskammer, die sich zwischen der isolierenden Platte 23 und dem Suszeptor 17 befindet.

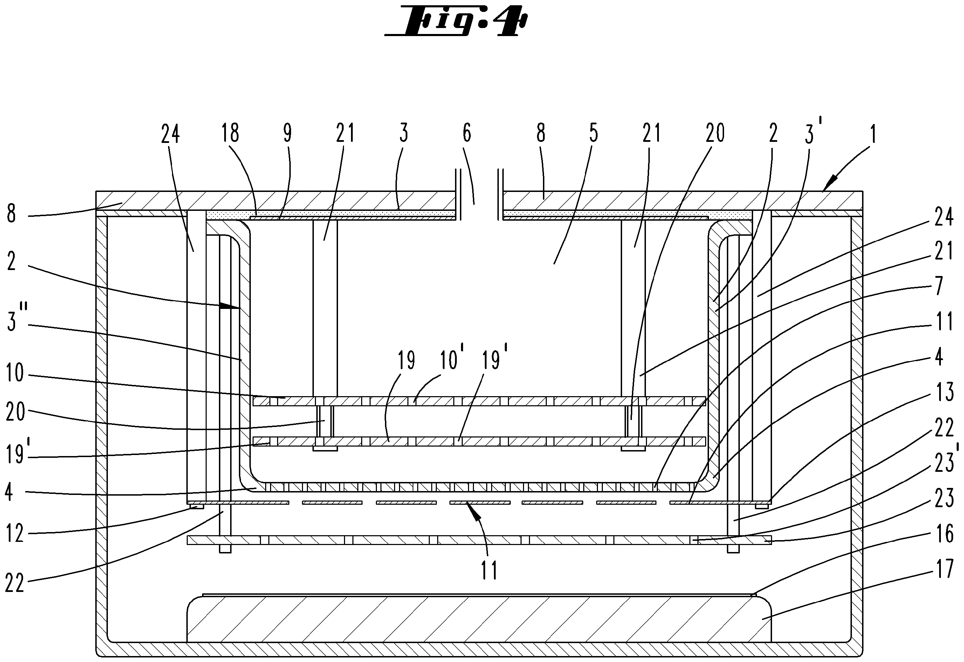

Bei dem in der Fig. 4 dargestellten vierten Ausführungsbeispiel besteht das Gaseinlassorgan 2 ebenfalls aus einem metallischen Hohlkörper, der an seiner Stirnseite Gasaustrittsöffnungen 7 besitzt. Auch hier befinden sich innerhalb der Gehäusehöhlung 5 zwei voneinander beabstandete, aus Metall bestehende Schirmelektroden 10, 19. Diese Schirmelektroden sind mit elektrisch leitenden Stangen 20, 21 an einer elektrisch leitenden und geerdeten Deckenplatte 8 befestigt.

Unterhalb der Deckenplatte 8 erstreckt sich eine aus einem isolierenden Werkstoff gefertigte Platte 18. Die Platte 18 liegt in berührender Anlage an der Deckenplatte 8.

In berührender Anlage an der isolierenden Platte 18 liegt die flächige Plasmaelektrode 9 an, die von einer Spannungsquelle spannungsbeaufschlagbar ist. Die Plasmaelektrode 9 und die isolierende Platte 18 besitzen Öffnungen, durch die die Haltestangen 21 hindurch treten. Diese Öffnungen sind in der Fig. 4 nicht dargestellt.

Die Gasheizung ist bei diesem Ausführungsbeispiel außerhalb des Gaseinlassorganes 2 angeordnet. Sie besteht aus einer dünnen Metallplatte, die mäanderförmig verlaufende oder spiralförmig verlaufende Schlitze aufweist. Hierdurch entsteht ein dünner Metallstreifen, der mit seinen Enden an Anschlusskontakten 12, 13 befestigt ist. Die Anschlusskontakte 12, 13 können am Ende von Haltestangen 24 sitzen, mit denen das Heizelement 11 in geringem Abstand unterhalb der Gasaustrittsöffnung 7 gehalten wird. Die Stromversorgung des Heizelementes 11 erfolgt durch die Haltestangen 24 hindurch. Die Haltestangen 24 können mit einer nicht dargestellten Isolierung umgeben sein und isolierend die Platte 8 durchdringen, so dass von außen her Strom durch die Haltestangen 24 hindurchgeleitet werden kann.

Zwischen der Oberfläche eines Suszeptors 17 und dem Heizelement 11 erstreckt sich eine kreisscheibenförmige Platte 23 aus einem isolierenden Werkstoff, die ebenfalls mit Haltestangen fixiert ist. Die Isolatorplatte 23 besitzt Öffnungen 23', durch die das dissoziierte und thermisch angeregte Prozessgas in Richtung auf das dem Suszeptor 17 liegende Substrat 16 strömen kann.

Auch hier erfolgt die Einleitung des Prozessgases durch eine Gaszuleitung 6 in die Gehäusehöhlung 5 des Gaseinlassorganes 2. Zwischen den geerdeten Platten 10, 19 und der davon isolierten Plasmaelektrode 9 bildet sich ein Plasma aus. Die ionisierten oder dissoziierten Ausgangsstoffe treten aus den Gasaustrittsöffnungen 7 in eine thermische Anregungszone, in der sich das Heizelement 11 befindet. Die thermische Anregungszone ist in Richtung auf den Suszeptor17 durch die isolierende Platte 23 begrenzt, durch deren Öffnungen 23' die thermisch aktivierten Ausgangsstoffe in Richtung des Substrates 16 austreten. Auch bei diesem Ausführungsbeispiel besitzt die Plasmaelektrode 9 zumindest eine Öffnung, durch die das Prozessgas hindurchtreten kann.

Die vorstehenden Ausführungen dienen der Erläuterung der von der Anmeldung insgesamt erfassten Erfindungen, die den Stand der Technik zumindest durch die folgenden Merkmalskombinationen jeweils eigenständig weiterbilden, nämlich:
Eine Vorrichtung, gekennzeichnet durch eine Gasheizeinrichtung 11 zur Unterstützung der Umformung, die stromabwärts der Bestandteile 8, 9,10 angeordnet ist.

Eine Vorrichtung, die dadurch gekennzeichnet ist, dass ein Gaseinlassorgan 2 in einer Prozesskammer eines CVD-Reaktors 1 angeordnet ist, welcher einen beheizbaren Suszeptor 17 aufweist, der ein Träger zur Aufnahme eines oder mehrerer Substrate 16 ist, wobei der Suszeptor 17 dem Boden einer Prozesskammer und die Gasaustrittsfläche 4 der Decke der Prozesskammer zugeordnet ist, welche Prozesskammer so ausgebildet ist, dass die aus der Gasaustrittsfläche 4 austretenden gasförmigen Zwischenprodukte zu dem mindestens einen Substrat 16 transportiert werden, auf dem die Nano-Strukturen abgeschieden werden.

Eine Vorrichtung, die dadurch gekennzeichnet ist, dass eine Plasmaelektrode 9 die Form eines Gitters oder einer Platte aufweist, welches im Strömungsweg des gasförmigen Ausgangsstoffes oder an der oberen Wandung 3 des Gaseinlassorgans 2 angeordnet ist.

Eine Vorrichtung, die gekennzeichnet ist durch eine oder mehrere Schirmelektroden 10, 19 in Form eines im Strömungsweg des gasförmigen Ausgangsstoffs angeordneten Gitters oder einer Durchtrittsöffnungen 10', 19' aufweisenden Platte 10, 19, wobei zumindest eine Schirmelektrode 8 stromaufwärts und/oder wobei zumindest eine Schirmelektrode 10, 19 stromabwärts der Plasmaelektrode 9 angeordnet ist.

Eine Vorrichtung, die dadurch gekennzeichnet ist, dass die Gasheizeinrichtung 11 die Form einer Platte, eines Gitters, eines Mäanders oder einer Spule aufweist, welche Heizeinrichtung insbesondere in einer sich quer zur Strömung erstreckenden Ebene im Strömungsweg des gasförmigen Ausgangsstoffes angeordnet ist, wobei die Gasheizeinrichtung 11 Anschlusselektroden 12, 13 aufweist zum Durchleiten eines elektrischen Stroms durch die Gasheizeinrichtung 11.

Eine Vorrichtung, die dadurch gekennzeichnet ist, dass die Schirmelektroden 8, 10, die Plasmaelektrode 9 und/oder die Gasheizung 11 von Platten ausgebildet sind, die jeweils eine Vielzahl von Öffnungen aufweisen, wobei die Öffnungen benachbarter Platten zum Zwecke einer Gasmischung versetzt zueinander angeordnet sind.

Eine Vorrichtung, die gekennzeichnet ist durch eine oder mehrere, die Elektroden 8, 9, 10 bildenden Platten und/oder die Innenseite der die Gasaustrittsöffnungen 7 aufweisende Wandung des Gaseinlassorganes 2 wärmereflektierende Eigenschaften aufweisen.

Eine Vorrichtung, die dadurch gekennzeichnet ist, dass die in einer Ebene angeordnete Gasheizeinrichtung 11 in Strömungsrichtung des Gases unmittelbar hinter der Gasaustrittsfläche 4 angeordnet ist und/oder eine Schirmelektrode 8 dem Substrat 16 unmittelbar gegenüber liegt, wobei die Schirmelektrode 8 Öffnungen 8' zum Gasdurchtritt aufweist.

Vorrichtung nach einem oder mehreren der vorhergehenden Ansprüche, dadurch gekennzeichnet, dass die obere Wandung 3 des Gasauslassorgans 2 eine Isolatorplatte 18 ist, entlang welcher sich die Plasmaelektrode 9 erstreckt.

Eine Vorrichtung, gekennzeichnet durch zwei voneinander beabstandete, innerhalb der Gehäusehöhlung 5 angeordnete Schirmelektroden 10,19, die mit elektrisch leitenden Haltestangen 20, 21 mit einer geerdeten Elektrode 8 verbunden sind.

Ein Verfahren, das dadurch gekennzeichnet ist, dass gegebenenfalls zusammen mit einem Trägergas eine Mischung beinhaltend zumindest einen oxidierenden oder reduzierenden oder kohlenstoffhaltigen gasförmigen Ausgangsstoff oder ein Reinigungsgas durch die Gaszuleitung 6 in die Gehäusehöhlung 5 eingespeist wird, wobei die Gasmischung sowohl vom Plasmagenerator 8, 9, 10 als auch von der Gasheizung 11 energiebeaufschlagt wird.

Ein Verfahren, das dadurch gekennzeichnet ist, dass der gasförmige Ausgangsstoff in der Gehäusehöhlung gleichzeitig durch Zufuhr von der Heizeinrichtung 11 erzeugten Wärme und durch ein vom Plasmagenerator 8, 9,10 erzeugtes Plasma aktiviert und dissoziiert wird, so dass sich atomare oder ionisierte Radikale, gasförmige Polymere oder aromatische Zwischenprodukte bilden, insbesondere in Form von Radikalen.

Ein Verfahren, das dadurch gekennzeichnet ist, dass das Plasma kontinuierlich erzeugt wird oder pulsförmig und/ oder, dass der gasförmige Ausgangsstoff kontinuierlich oder pulsförmig in das Gaseinlassorgan 2 eingespeist wird.

Ein Verfahren, das dadurch gekennzeichnet ist, dass vor oder nach einem Verfahrensschritt, bei dem auf dem in der Prozesskammer angeordneten Substrat 16 aus Kohlenstoff bestehende Nano-Strukturen abgeschieden werden, ein Reinigungsschritt durchgeführt wird, bei dem ein in die Gehäusehöhlung 5 eingespeistes Reinigungsgas durch Beaufschlagen durch ein Plasma und/ oder durch Aufheizen aktiviert wird, wobei der Reinigungsschritt insbesondere periodisch vor oder nach einem Abscheideschritt durchgeführt wird.

Ein Verfahren, das dadurch gekennzeichnet ist, dass mit insbesondere geerdeten, stromabwärts der Plasmaelektrode 9 und/oder der Heizeinrichtung 13 angeordneten Elementen, wie eine Schirmelektrode 10 und/ oder der geerdeten Gasaustrittsfläche 4 sich bei der Umformungsreaktion bildende Partikel gefangen werden.

Alle offenbarten Merkmale sind (für sich, aber auch in Kombination untereinander) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen.

**Bezugszeichenliste**

| | | | | | |
|---|---|---|---|---|---|
| 1 | Reaktorgehäuse | | | | |
| 2 | Gaseinlassorgan/shower head | | | | |
| 3 | Wandung | 3' | Wandung | 3" | Wandung |
| 4 | Gasaustrittsfläche | | | | |
| 5 | Gehäusehöhlung | | | | |
| 6 | Gaszuleitung | | | | |
| 7 | Gasaustrittsöffnung | | | | |
| 8 | Platten | 8' | Öffnung | | |
| 9 | Plasmaelektrode/Platte | | | | |
| 10 | Platten | 10' | Öffnung | | |
| 11 | Heizelement, Platte, Mäander oder Spule | | | | |
| 12 | Kontakt | | | | |
| 13 | Kontakt | | | | |
| 14 | Hochspannungsquelle | | | | |
| 15 | Heizspannungsquelle | | | | |
| 16 | Substrat | | | | |
| 17 | Suszeptor | | | | |
| 18 | Isolatorplatte | | | | |
| 19 | Platte | 19' | Öffnung | | |
| 20 | Haltestange | | | | |
| 21 | Haltestange | | | | |
| 22 | Haltestange | | | | |
| 23 | Platte | | | | |
| 24 | Haltestangen | | | | |

## Patentansprüche

1. Vorrichtung zum Fertigen von aus Kohlenstoff bestehenden Nano-Strukturen, wie Monolagen, Multilayerschichtstrukturen, Röhrchen oder Fasern, aufweisend ein Gaseinlassorgan (2) mit einer von Gehäusewänden (3, 3', 3") umschlossenen Gehäusehöhlung (5), in die eine Gaszuleitung (6) mündet, durch die ein gasförmiger, insbesondere kohlenstoffhaltiger Ausgangsstoff in die Gehäusehöhlung (5) einspeisbar ist, mit einem zumindest teilweise in der Gehäusehöhlung (5) angeordnete Bestandteile (8, 9, 10) aufweisenden Plasmagenerator, der zumindest eine mit einer elektrischen Spannung beaufschlagbare Plasmaelektrode (9) aufweist, um den gasförmigen Ausgangsstoff durch Zünden eines Plasmas mit Energie zu beaufschlagen und so in ein gasförmiges Zwischenprodukt umzuformen, und mit einer eine Vielzahl von Gasaustrittsöffnungen (7) aufweisenden Gasaustrittsfläche (4) durch die das gasförmige Zwischenprodukt aus der Gehäusehöhlung (5) austreten kann, und mit einer Gasheizeinrichtung (11) zur Unterstützung der Umformung, die stromabwärts der Bestandteile (8, 9, 10) angeordnet ist, **gekennzeichnet durch** eine stromabwärts der Gasheizeinrichtung (11) angeordnete Platte (23) aus einem isolierendem Werkstoff, welche Öffnungen (23') aufweist, durch die das dissoziierte und thermisch angeregt Prozessgas in Richtung auf das auf dem Suszeptor (17) liegende Substrat (16) strömen kann.

2. Vorrichtung nach Anspruch 1, **dadurch gekennzeichnet, dass** das Gaseinlassorgan (2) in einer Prozesskammer eines CVD-Reaktors (1) angeordnet ist, welcher einen beheizbaren Suszeptor (17) aufweist, der ein Träger zur Aufnahme eines oder mehrerer Substrate (16) ist, wobei der Suszeptor (17) dem Boden einer Prozesskammer und die Gasaustrittsfläche (4) der Decke der Prozesskammer zugeordnet ist, welche Prozesskammer so ausgebildet ist, dass die aus der Gasaustrittsfläche (4) austretenden gasförmigen Zwischenprodukte zu dem mindestens einem Substrat (16) transportiert werden, auf dem die Nano-Strukturen abgeschieden werden.

3. Vorrichtung nach einem der vorherigen Ansprüche, **dadurch gekennzeichnet, dass** die Plasmaelektrode (9) die Form eines Gitters oder einer Platte aufweist und die Plasmaelektrode (9) im Strömungsweg des gasförmigen Ausgangsstoffes oder an der oberen Wandung (3) des Gaseinlassorgans (2) angeordnet ist.

4. Vorrichtung nach einem der vorherigen Ansprüche, **gekennzeichnet durch** eine oder mehrere Schirmelektroden (10, 19) jeweils in Form eines im Strömungsweg des gasförmigen Ausgangsstoffs angeordneten Gitters oder einer Durchtrittsöffnungen (10', 19') aufweisenden Platte (10, 19), wobei zumindest eine Schirmelektrode (8) stromaufwärts und/oder wobei zumindest eine Schirmelektrode (10, 19) stromabwärts der Plasmaelektrode (9) angeordnet ist.

5. Vorrichtung nach einem der vorherigen Ansprüche, **dadurch gekennzeichnet, dass** die Gasheizeinrichtung (11) die Form einer Platte, eines Gitters, eines Mäanders oder einer Spule aufweist, welche Gasheizeinrichtung (11) insbesondere in einer sich quer zur Strömung erstreckenden Ebene im Strömungsweg des gasförmigen Ausgangsstoffes angeordnet ist, wobei die Gasheizeinrichtung (11) Anschlusselektroden (12, 13) aufweist zum Durchleiten eines elektrischen Stroms durch die Gasheizeinrichtung (11).

6. Vorrichtung nach einem der Ansprüche 4 oder 5, **dadurch gekennzeichnet, dass** die Schirmelektroden (8, 10), die Plasmaelektrode (9) und/ oder die Gasheizeinrichtung (11) von Platten ausgebildet sind, die jeweils eine Vielzahl von Öffnungen aufweisen, wobei die Öffnungen benachbarter Platten zum Zwecke einer Gasmischung versetzt zueinander angeordnet sind.

7. Vorrichtung nach einem der vorherigen Ansprüche, **dadurch gekennzeichnet, dass** ein oder mehrere, die Elektroden (8, 9, 10) bildenden Platten und/ oder die Innenseite der die Gasaustrittsöffnungen (7) aufweisende Wandung des Gaseinlassorganes (2) wärmereflektierende Eigenschaften aufweisen.

8. Vorrichtung nach einem der vorhergehenden Ansprüche, **dadurch gekennzeichnet, dass** die in einer Ebene angeordnete Gasheizeinrichtung (11) in Strömungsrichtung des Gases unmittelbar hinter der Gasaustrittsfläche (4) angeordnet ist und/ oder eine Schirmelektrode (8) dem Substrat (16) unmittelbar gegenüber liegt, wobei die Schirmelektrode (8) Öffnungen (8') zum Gasdurchtritt aufweist.

9. Vorrichtung nach einem der vorhergehenden Ansprüche, **dadurch gekennzeichnet, dass** die obere Wandung (3) des Gaseinlassorgans (2) eine Isolatorplatte (18) ist, entlang welcher sich die Plasmaelektrode (9) erstreckt.

10. Vorrichtung nach einem der vorhergehenden Ansprüche, **gekennzeichnet durch** zwei voneinander beabstandete, innerhalb der Gehäusehöhlung (5) angeordnete Schirmelektroden (10, 19), die mit elektrisch leitenden Haltestangen (20, 21) mit einer geerdeten Elektrode (8) verbunden sind.

11. Verfahren zur Fertigung von aus Kohlenstoff bestehenden Nano-Strukturen wie Monolagen, Multilayerschichtstrukturen, Röhrchen oder Fasern, in einer Vorrichtung gemäß einem der vorhergehenden Ansprüche, **dadurch gekennzeichnet, dass** gegebenenfalls zusammen mit einem Trägergas eine Mischung beinhaltend zumindest einen oxidierenden oder reduzierenden oder kohlenstoffhaltigen gasförmigen Ausgangsstoff oder ein Reinigungsgas durch die Gaszuleitung (6) in die Gehäusehöhlung (5) eingespeist wird, wobei die Gasmischung sowohl vom Plasmagenerator (8, 9, 10) als auch von der Gasheizeinrichtung (11) energiebeaufschlagt wird.

12. Verfahren nach Anspruch 11, **dadurch gekennzeichnet, dass** der gasförmige Ausgangsstoff in der Gehäusehöhlung gleichzeitig durch Zufuhr von der Gasheizeinrichtung (11) erzeugten Wärme und durch ein vom Plasmagenerator (8, 9, 10) erzeugtes Plasma aktiviert und dissoziiert wird, so dass sich atomare oder ionisierte Radikale, gasförmige Polymere oder aromatische Zwischenprodukte bilden, insbesondere in Form von Radikalen, wobei das Plasma kontinuierlich erzeugt wird oder pulsförmig und/ oder, dass der gasförmige Ausgangsstoff kontinuierlich oder pulsförmig in das Gaseinlassorgan (2) eingespeist wird.

13. Verfahren nach Anspruch 10, 11 oder 12, **dadurch gekennzeichnet, dass** vor oder nach einem Verfahrensschritt, bei dem auf dem in der Prozesskammer angeordneten Substrat (16) aus Kohlenstoff bestehende Nano-Strukturen abgeschieden werden, ein Reinigungsschritt durchgeführt wird, bei dem ein in die Gehäusehöhlung (5) eingespeistes Reinigungsgas durch Beaufschlagen durch ein Plasma und/ oder durch Aufheizen aktiviert wird, wobei der Reinigungsschritt insbesondere periodisch vor oder nach einem Abscheideschritt durchgeführt wird.

14. Verfahren nach einem der Ansprüche 11 bis 13, **dadurch gekennzeichnet, dass** mit insbesondere geerdeten, stromabwärts der Plasmaelektrode (9) und/ oder der Heizeinrichtung (13) angeordneten Elementen, wie eine Schirmelektrode (10) und/ oder der geerdeten Gasaustrittsfläche (4) sich bei der Umformungsreaktion bildende Partikel gefangen werden.

## Claims

1. Apparatus for producing nanostructures consisting of carbon, such as monolayers, multilayer coating structures, tubes or fibers, comprising a gas inlet member (2) having a housing cavity (5) enclosed by housing walls (3, 3', 3"), into which cavity a gas supply line (6) leads through which a gaseous, in particular carbon-containing starting material can be fed into the housing cavity (5), comprising a plasma generator which has components (8, 9, 10) arranged at least in part in the housing cavity (5) and has at least one plasma electrode (9) to which an electrical voltage can be applied, in order to energize the gaseous starting material by igniting a plasma and thus to transform said starting material into a gaseous intermediate product, and comprising a gas outlet surface (4) which has a plurality of gas outlet openings (7) and through which the gaseous intermediate product can exit the housing cavity (5), and comprising a gas heating device (11) for assisting the transformation, which device is arranged downstream of the components (8, 9, 10), **characterized by** a plate (23) which is arranged downstream of the gas heating device (11), is made of an insulating material and has openings (23') through which the dissociated and thermally excited process gas can flow towards the substrate (16) located on the susceptor (17).

2. Apparatus according to claim 1, **characterized in that** the gas inlet member (2) is arranged in a process chamber of a CVD reactor (1) which has a heatable susceptor (17) that is a support for receiving one or more substrates (16), the susceptor (17) being associated with the bottom of a process chamber and the gas outlet surface (4) being associated with the top of the process chamber, which process chamber is designed such that the gaseous intermediate products exiting the gas outlet surface (4) are transported to the at least one substrate (16) on which the nanostructures are deposited.

3. Apparatus according to either of the preceding claims, **characterized in that** the plasma electrode (9) is in the form of a grid or a plate and the plasma electrode (9) is arranged in the flow path of the gaseous starting material or on the upper wall (3) of the gas inlet member (2).

4. Apparatus according to any of the preceding claims, **characterized by** one or more shield electrodes (10, 19), each of which is in the form of a grid arranged in the flow path of the gaseous starting material, or a plate (10, 19) which comprises passage openings (10' 19'), at least one shield electrode (8) being arranged upstream and/or at least one shield electrode (10, 19) being arranged downstream of the plasma electrode (9).

5. Apparatus according to any of the preceding claims, **characterized in that** the gas heating device (11) is in the form of a plate, a grid, a meander or a coil, which gas heating device (11) is arranged in particular in a plane extending transversely to the flow in the flow path of the gaseous starting material, the gas heating device (11) comprising terminal electrodes (12, 13) for conducting an electrical current through the gas heating device (11).

6. Apparatus according to either claim 4 or claim 5, **characterized in that** the shield electrodes (8, 10), the plasma electrode (9) and/or the gas heating device (11) are formed by plates each having a plurality of openings, the openings of adjacent plates being arranged so as to be mutually offset for the purpose of gas mixing.

7. Apparatus according to any of the preceding claims, **characterized in that** one or more plates forming the electrodes (8, 9, 10) and/or the internal face of the wall of the gas inlet member (2) having the gas outlet openings (7) have heat-reflecting properties.

8. Apparatus according to any of the preceding claims, **characterized in that** the gas heating device (11), arranged in a plane, is arranged directly behind the gas outlet surface (4) in the flow direction of the gas and/or a shield electrode (8) lies directly opposite the substrate (16), the shield electrode (8) having openings (8') for the gas to pass through.

9. Apparatus according to any of the preceding claims, **characterized in that** the upper wall (3) of the gas inlet member (2) is an insulator plate (18) along which the plasma electrode (9) extends.

10. Apparatus according to any of the preceding claims, **characterized by** two shield electrodes (10, 19), which are spaced apart from one another and are arranged within the housing cavity (5), and which are connected to a grounded electrode (8) by electrically conductive retaining rods (20, 21).

11. Method for producing nanostructures consisting of carbon, such as monolayers, multilayer coating structures, tubes or fibers, in an apparatus according to any of the preceding claims, **characterized in that**, optionally together with a carrier gas, a mixture containing at least one oxidizing or reducing or carbon-containing gaseous starting material or a cleaning gas is fed through the gas supply line (6) and into the housing cavity (5), the gas mixture being energized by both the plasma generator (8, 9, 10) and the gas heating device (11).

12. Method according to claim 11, **characterized in that** the gaseous starting material in the housing cavity is simultaneously activated and dissociated by supplying heat generated by the gas heating device (11) and by a plasma generated by the plasma generator (8, 9, 10), so as to form atomic or ionized radicals, gaseous polymers or aromatic intermediate products, in particular in the form of radicals, the plasma being generated continuously or in pulses, and/or **in that** the gaseous starting material is fed continuously or in pulses into the gas inlet member (2).

13. Method according to claims 10, 11 or 12, **characterized in that**, before or after a method step in which nanostructures consisting of carbon are deposited on the substrate (16) arranged in the process chamber, a cleaning step is carried out in which a cleaning gas fed into the housing cavity (5) is activated by the application of a plasma and/or by heating, the cleaning step being performed in particular periodically before or after a deposition step.

14. Method according to any of claims 11 to 13, **characterized in that** particles forming during the transformation reaction are captured by elements, such as a shield electrode (10) and/or the grounded gas outlet surface (4), which are in particular grounded and arranged downstream of the plasma electrode (9) and/or the heating device (13).

## Revendications

1. Dispositif pour la fabrication de nanostructures en carbone, telles que des monocouches, des structures multicouches, des tubes ou des fibres, comprenant un organe d'entrée de gaz (2), une cavité de boîtier (5) entourée par des parois de boîtier (3, 3', 3") dans laquelle débouche une conduite d'alimentation en gaz (6) par laquelle un produit gazeux de départ contenant en particulier du carbone peut être introduit dans la cavité de boîtier (5), un générateur de plasma qui présente des composants (8, 9, 10) agencés au moins en partie dans la cavité de boîtier (5) et qui comprend au moins une électrode à plasma (9) à laquelle peut être appliquée une tension électrique pour appliquer de l'énergie au produit gazeux de départ par amorçage d'un plasma et le transformer ainsi en un produit gazeux intermédiaire, une surface de sortie de gaz (4) présentant une multiplicité d'ouvertures de sortie de gaz (7) et à travers laquelle le produit gazeux intermédiaire peut sortir de la cavité de boîtier (5), et un dispositif de chauffage de gaz (11) pour promouvoir la transformation lequel est agencé en aval des composants (8, 9, 10), **caractérisé par** une plaque (23) en matériau isolant agencée en aval dudit dispositif de chauffage de gaz (11) laquelle présente des ouvertures (23') à travers lesquelles le gaz de traitement dissocié et excité thermiquement peut s'écouler vers le substrat (16) disposé sur le suscepteur (17).

2. Dispositif selon la revendication 1, **caractérisé en ce que** l'organe d'entrée de gaz (2) est disposé dans une chambre de traitement d'un réacteur CVD (1) qui comprend un suscepteur (17) pouvant être chauffé et lequel est un support pour recevoir un ou plusieurs substrats (16), dans lequel le suscepteur (17) est associé au fond d'une chambre de traitement et la surface de sortie de gaz (4) est associée au plafond de la chambre de traitement, laquelle chambre de traitement est conçue de manière que les produits gazeux intermédiaires sortant de la surface de sortie de gaz (4) soient transportés au niveau de l'au moins un substrat (16) sur lequel sont déposées les nanostructures.

3. Dispositif selon l'une des revendications précédentes, **caractérisé en ce que** l'électrode à plasma (9) présente la forme d'une grille ou d'une plaque et l'électrode à plasma (9) est agencée dans le trajet d'écoulement du produit gazeux de départ ou au niveau de la paroi supérieure (3) de l'organe d'entrée de gaz (2).

4. Dispositif selon l'une des revendications précédentes, **caractérisé par** une ou plusieurs électrodes de blindage (10, 19) se présentant chacune sous la forme d'une grille ou d'une plaque (10, 19) présentant des ouvertures de passage (10', 19'), laquelle est agencée dans le trajet d'écoulement du produit gazeux de départ, dans lequel au moins une électrode de blindage (8) est agencée en amont de l'électrode de plasma (9) et/ou dans lequel au moins une électrode de blindage (10, 19) est agencée en aval de l'électrode de plasma (9).

5. Dispositif selon l'une des revendications précédentes, **caractérisé en ce que** le dispositif de chauffage de gaz (11) a la forme d'une plaque, d'une grille, d'un méandre ou d'une bobine, lequel dispositif de chauffage de gaz (11) est agencé en particulier dans un plan s'étendant transversalement à l'écoulement dans le trajet d'écoulement du produit gazeux de départ, le dispositif de chauffage de gaz (11) comportant des électrodes de raccordement (12, 13) pour le passage de courant électrique à travers le dispositif de chauffage de gaz (11).

6. Dispositif selon l'une des revendications 4 ou 5, **caractérisé en ce que** les électrodes de blindage (8, 10), l'électrode à plasma (9) et/ou le dispositif de chauffage de gaz (11) sont formés par des plaques présentant chacune une pluralité d'ouvertures, les ouvertures de plaques qui sont adjacentes étant décalées les unes par rapport aux autres aux fins de mélangeage de gaz.

7. Dispositif selon l'une des revendications précédentes, **caractérisé en ce qu'**une ou plusieurs plaques formant les électrodes (8, 9, 10) et/ou le côté intérieur de la paroi de l'organe d'entrée de gaz (2) présentant les ouvertures de sortie de gaz (7) ont des propriétés de réflexion de la chaleur.

8. Dispositif selon l'une des revendications précédentes, **caractérisé en ce que** le dispositif de chauffage de gaz (11) agencé dans un plan, est agencé, dans la direction d'écoulement du gaz, directement derrière la surface de sortie de gaz (4) et/ou une électrode de blindage (8) est disposée directement en face du substrat (16), l'électrode de blindage (8) présentant des ouvertures (8') pour le passage de gaz.

9. Dispositif selon l'une des revendications précédentes, **caractérisé en ce que** la paroi supérieure (3) de l'organe d'entrée de gaz (2) est une plaque d'isolation (18) le long de laquelle s'étend l'électrode à plasma (9).

10. Dispositif selon l'une des revendications précédentes, **caractérisé par** deux électrodes de blindage (10, 19) espacées l'une de l'autre qui sont agencées à l'intérieur de la cavité de boîtier (5) et qui sont reliées à une électrode (8) qui est reliée à la terre par des barres de support électriquement conductrices (20, 21).

11. Procédé de fabrication de nanostructures en carbone telles que des monocouches, des structures multicouches, des tubes ou des fibres, dans un dispositif selon l'une des revendications précédentes, **caractérisé en ce qu'**un mélange contenant au moins un produit gazeux de départ qui est oxydant, réducteur ou qui contient du carbone ou un gaz de nettoyage est amené, le cas échéant ensemble avec un gaz porteur, dans la cavité de boîtier (5) par la conduite d'alimentation en gaz (6), dans lequel de l'énergie est apportée au mélange gazeux à la fois par le générateur de plasma (8, 9, 10) et le dispositif de chauffage de gaz (11).

12. Procédé selon la revendication 11, **caractérisé en ce que** le produit gazeux de départ dans la cavité du boîtier est activé et dissocié simultanément par l'apport de chaleur générée par le dispositif de chauffage de gaz (11) et par un plasma généré par le générateur de plasma (8, 9, 10), de manière que se forment des radicaux atomiques ou ionisés des polymères gazeux ou des produits intermédiaires aromatiques, en particulier sous forme de radicaux, dans lequel le plasma est produit en continu ou sous forme d'impulsions et/ou **en ce que** le produit gazeux de départ est introduit en continu ou sous forme d'impulsions dans l'organe d'entrée de gaz (2).

13. Procédé selon la revendication 10, 11 ou 12, **caractérisé en ce qu'**avant ou après une étape de procédé dans laquelle des nanostructures de carbone sont déposées sur le substrat (16) agencé dans la chambre de traitement, une étape de nettoyage est exécutée dans laquelle un gaz de nettoyage introduit dans la cavité de boîtier (5) est activé par l'action d'un plasma et/ou par chauffage, dans lequel l'étape de nettoyage est en particulier exécutée périodiquement avant ou après une étape de dépôt.

14. Procédé selon l'une des revendications 11 à 13, **caractérisé en ce que** des particules se formant pendant la réaction de transformation sont piégées par, en particulier, des éléments mis à la terre disposés en aval de l'électrode à plasma (9) et/ou du dispositif de chauffage (13), tels qu'une électrode de blindage (10) et/ou la surface de sortie de gaz (4) reliée à la terre.
